# EUROPÄISCHE PATENTANMELDUNG

(11) **EP 1 225 645 A2**
(43) Veröffentlichungstag der Anmeldung: **24.07.2002**
(21) Anmeldenummer: 02001015.3
(22) Anmeldetag: 17.01.2002
(51) Int. Cl.: H01L 41/083, H01L 41/24

(54) **Festkörperaktor und Verfahren zu dessen Herstellung**

(30) Priorität: 17.01.2001 EP 01100183
(71) Anmelder: Piezomechanik GmbH, 81673 München (DE)
(72) Erfinder: Dr. Pickelmann, Lutz, 81673 München (DE)
(74) Vertreter: Schwabe - Sandmair - Marx

(57) **Zusammenfassung**

Die Erfindung betrifft ein Verfahren zur Herstellung von Festkörperaktoren, insbesondere Piezoaktoren, wobei Aktorenabschnitte 12, hergestellt werden zwischen diesen Kontaktelektroden vorgesehen werden, wobei erfindungsgemäß die Kontaktelektroden wenigstens eine duktile Schicht, bzw. eine Schicht mit einem Material mit einer Mohs-Härte von weniger als 2,5 vorgesehen wird.

## Beschreibung

Die Erfindung betrifft ein Verfahren zur Herstellung von Festkörperaktoren, insbesondere Piezokeramikaktoren, wobei Aktorenabschnitte, insbesondere Piezoaktorenabschnitte, hergestellt werden, und Kontaktelektroden bereitgestellt werden, wobei diese mit den Aktorenabschnitten in Verbindung gebracht werden, gemäß dem Oberbegriff des Patentanspruchs 1. Ferner betrifft die Erfindung einen Festkörperaktor und insbesondere einen Piezokeramikaktor gemäß dem Oberbegriff des Patentanspruchs 5.

Im Stand der Technik sind Festkörperaktoren und insbesondere piezokeramische Aktoren bekannt, die aus einer Vielzahl von beispielsweise gefügten Scheiben aus piezokeramischem Material zusammengesetzt sind. Zwischen den Scheiben werden Kontaktelektroden vorgesehen. An die Kontaktelektroden wird eine Spannung angelegt und die Spannung sorgt für den Aufbau eines elektrischen Feldes zwischen den Kontaktelektroden, so dass auf das piezokeramische Material ein elektrisches Feld einwirkt, das dazu führt, dass das piezokeramische Material eine Längenerstreckung bzw. -ausdehnung erfährt. Dabei ist es vorteilhaft, wenn die einzelnen Komponenten, wie auch der Festkörper- bzw. der entsprechende Piezostapelaktor möglichst steif sind, da die Kraft und die Ausdehnung über den feldfreien Ruhezustand hinaus, die ein Piezostapelaktor bzw. Festkörperaktor erzielen kann, durch die Steifigkeit der Gesamtanordnung wesentlich mitbestimmt wird.

Hochsteife Piezo- bzw. Piezostapelaktoren, die lediglich kleine Messungen aufweisen, können selbst bei geringem elektrischen Ansteuerungsaufwand wenigstens im Wesentlichen die gleichen antriebstechnischen Eigenschaften bereitstellen, wie ein beispielsweise größerer Aktor, der aus vielen schlecht zusammengefügten Piezoaktorscheiben zusammengesetzt ist.

Eine herkömmliche Art der Herstellung eines Piezostapelaktors nach dem Stand der Technik sieht vor, dass Scheiben oder Folien aus piezokeramischem Material über Kontaktelektroden zusammengefügt werden, die zwischen die einzelnen piezokeramischen Scheiben oder Folien gelegt werden. In der Regel sind die Kontaktelektroden als Messing-, Kupfer- oder Bronzefolien ausgebildet, die eine Dicke von etwa 10 bis ca. 50 µm aufweisen können. Eine derartige Stapelreihenfolge aus Piezoscheiben bzw. Piezofolien und Kontaktelektrodenfolien wird dann verklebt oder mittels einer Zwingmechanik als Stapel angeordnet und gehandhabt.

Derartige nach dem Stand der Technik hergestellte Festkörperaktoren bzw. Piezoaktoren weisen eine Steifigkeit auf, die ganz erheblich unterhalb der theoretischen Steifigkeit der Piezoaktorabschnitte selbst liegt. Ferner ist anzumerken, dass Kupfer oder Kupferlegierungen für die Kontaktierung der hier beschriebenen diskreten Stapelaktoren eingesetzt werden, da diese mittels herkömmlicher Löttechniken einfach zu kontaktieren sind.

Wird ein Stapelaktor mit Fugen hoher mechanischer Steifigkeit hergestellt, wobei ohne eine Metalleinlage die Piezoscheiben oder -folien unmittelbar miteinander gefügt und verklebt werden, treten innerhalb dieses Aktors hohe mechanische Spannungen auf. Diese verringern die Lebensdauer eines derartigen Aktorsystems ganz entscheidend.

Dementsprechend gibt es im Stand der Technik einen Bedarf nach Festkörper- bzw. Piezoaktoren, die einerseits eine hohe Steifigkeit aufweisen und bei denen andererseits innere Spannungen vermieden werden können, die die Lebensdauer eines über ein elektrisches Feld gesteuerten Aktor vermindern könnten.

Diese Aufgabe wird erfindungsgemäß durch ein Verfahren bzw. einen Festkörperaktor gemäß dem Anspruch 1 bzw. gemäß dem Anspruch 5 gelöst.

Zweckmäßige Ausführungsformen der erfindungsgemäßen Gegenstände gehen aus den Unteransprüchen hervor.

Die gemäß der Erfindung erzielbaren Vorteile basieren auf einem durch ein elektrisches Feld gesteuerten Festkörperaktor etwa aus einer Piezokeramik oder aus Elektrostriktoren, wobei zwischen den einzelnen Abschnitten eines derartigen Aktors Kontaktelektroden mit wenigstens einer Schicht mit einem Material mit einer Mohs-Härte von weniger als 2,5 vorgesehen wird, das bevorzugt auch ein kleines E-Modul aufweist. Beim Fügen bzw. Anordnen von Akorabschnitten kann sich eine weiche Metallfolie bzw. eine weiche Metallschicht, evtl. auch etwa eine Graphitschicht oder dgl. den Oberflächen von angrenzenden Aktorabschnitten anpassen und kann dadurch die Erstreckung einer Fuge ganz erheblich verringern. D.h., Material der einzubringenden Schicht, das ein weiches Material ist, wandert in Vertiefungen, Unebenheiten oder dgl., die in der Praxis leicht entstehen, und sorgt für einen Ausgleich in Bezug auf einen angrenzenden Festkörperaktorabschnitt. An Festaktoren hat sich überraschenderweise gezeigt, dass die Folieneinlagen aus weichen bzw. duktilen Metallen, bevorzugt mit einer Mohs-Härte von weniger als 2,5, eine besondere Steifigkeit aufweisen, wobei darüber hinaus die Lebensdauer gemäß der Erfindung ausgebildeter bzw. hergestellter Festkörperaktoren wesentlich verlängert werden kann. Dies wird darauf zurückgeführt, dass die durch die erfindungsgemäß vorzusehende Schicht hervorgerufene Oberflächenanpassung zu einer Verringerung der mechanischen Spannungen und damit zu einer internen Stressminderung führt.

Alternativ oder kumulativ weist das Material, das wenigstens ein Schicht zwischen den Aktorabschnitten ausmacht, eine bestimmte Prägbarkeit auf, so dass sich dieses Material optimiert an die Oberfächenrauhigkeit der angrenzenden Aktorabschnitte anpasst. Wirken dann im Betrieb Kräfte auf den Aktorstapel mit den erfindungsgemäß vorzusehenden Zwischenschichten, die sogleich auch als Elektroden dienen können, ist die Steifigkeit des Aktorstapels wesentlich verbessert. Hierdurch treten innerhalb des Aktorstapels kaum destruktive Kräfte auf, die etwa Mikrorisse oder Risse innerhalb der Aktorabschnitte verursachen könnten und die gesamte Kristallgitterverzerrung oder -bewegung kann in eine gleichbleibende Längenänderung des Aktorstapels umgesetzt werden. In diesem Sinne ist es auch gerechtfertigt, in Bezug auf das Material der Zwischenschicht oder wenigstens einer Schicht hiervon, von einer guten Prägbarkeit zu sprechen, wobei das E-Modul des Materials bevorzugt mit dem des Aktormaterials übereinstimmt. In der Praxis wird in der Regel nur eine Annährung der E-Module möglich sein. Bezüglich der Prägbarkeit kann die Brinellhärte als Einheit herangezogen werden. Reines Aluminium etwa, welches sich besonders als eine Schicht des Elektrodenmaterials eignet, bzw. aus dem die gesamte Zwischenschichten ausgebildet sein können, hat eine Brinellhärte von ca. 15 kp/mm².

Als Material für die wenigstens eine Schicht der Zwischenschicht, bzw. die Zwischenschicht insgesamt ist ein Material mit einer Brinellhärte von kleiner oder gleich ca. 40 kp/mm² und bevorzugt von kleiner oder gleich ca. 25 bis 30 kp/mm² zu wählen. Auch dieses Material sollte bevorzugt ein E-Modul der gleichen Größenordnung wie das Material der Aktor- bzw. Piezomaterialabschnitte haben. Auch eine technische ausreichende Kontaktierbarkeit und elektrische Leitfähigkeit sollte vorzugsweise gegeben sein.

Es ist natürlich auch möglich, die erfindungsgemäß vorzusehende wenigstens eine Schicht nicht unmittelbar als an eine Spannungsquelle anschließbare Kontaktelektrode auszubilden, sondern lediglich als Oberflächenanpassungs- und Stressminderungsschicht, und zusätzlich eine Kontaktfolie, etwa herkömmlicher Art, aus Kupfer und seinen Legierungen, oder anderen bekanntermaßen eingesetzten Materialien vorzusehen. Hierbei kann es auch vorgesehen werden, dass beidseits einer derartigen zu kontaktierenden Metallfolie jeweils eine Schicht der erfindungsgemäß vorzusehenden Art angeordnet wird, um für die gewünschte Oberflächenanpassung sowie die dadurch bedingte Versteifung und die gewünschte interne Stressminderung zu sorgen.

Wenn als Kontaktelektrode eine weitere Schicht bzw. Folie oder dgl. vorgesehen wird, kann die erfmdungsgemäß vorzusehende, wenigstens eine Schicht auch aus einem elektrisch nicht leitenden Material sein, wobei es jedoch zu bevorzugen sein wird, wenn die erfindungsgemäß vorgesehene wenigstens eine Schicht ein Metall aufweist.

Die vorzusehende, wenigstens eine Schicht kann in beliebiger Art und Weise angeordnet werden. Sie kann nicht nur in Form einer Folie angeordnet werden, sondern es ist auch möglich, entsprechendes Material auf die Oberflächen der Aktorenabschnitte, die im montierten Zustand im Stapel aneinander angrenzen sollen, aufzudampfen, evtl. aufzusputern, galvanisch aufzutragen oder dgl. Auch ist es möglich, die übliche Kontaktelektrode in der Form einer Kupferfolie mit einer oder mehreren Schichten aus weichem, prägbarem Material zu versehen, so dass die erfmdungsgemäß angestrebte Funktion wiederum erfüllt werden kann.

Wie eingangs angedeutet, werden im Stand der Technik herkömmlicherweise härtere Metalle, wie etwa Kupfer oder auch Einbrennsilberschichten, chemisch abgeschiedene Metallisierungen von Nickel/Gold oder Sputter-/Aufdampfschichten verschiedener harter Metalle, wie etwa Wolfram, Palladium oder dgl., eingesetzt. Kupfer, weich, weist bspw. eine Brinellhärte von ca. 45 kp/mm² auf. (Messing: ca. 70 - 100 kp/mm²). Auch entsprechend der verwendeten Technologie sind die erzeugten Schichten sehr dünn herstellbar und werden üblicherweise in Dicken von 1 µm oder sogar weniger auf den Fügeflächen der Festkörperaktorabschnitte aufgebracht. Einerseits können diese Schichten dementsprechend bereits aufgrund ihrer mangelnden Dicke und andererseits wegen ihrer großen Härte von mehr als 2,5 und üblicherweise mehr als 3 auf der Mohs-Härteskala bzw. ihrer geringen Prägbarkeit die gewünschten und gemäß der Erfindung erzielbaren Vorteile nicht bewerkstelligen.

Um den vorteilhaften Effekt erzielen zu können, dass die erfindungsgemäß vorzusehende Schicht Unebenheiten bzw. eine Porösität der angrenzenden Oberflächen der Aktorenabschnitte ausgleicht, ist es vorteilhaft, wenn die wenigstens eine Schicht mit einer Dicke von ca. 5 µm bis etwa 100 µm aufgebracht wird. Hier ist ausreichend weiches, prägbares Material vorhanden, das in Unebenheiten verdrängt werden kann und aufgrund seiner Duktilität eine ideale Fuge ausbilden kann, die praktisch weder dazu in der Lage ist, Stress zu induzieren noch zu Steifigkeitsverlusten führen kann.

Denkbar ist auch, mineralische Schichten aufzutragen, die zwar nicht elektrisch leitfähig sind, jedoch dennoch eine geringe Mohs-Härte bzw. eine gute Prägbarkeit aufweisen, wobei ansonsten eine Schicht eines herkömmlich eingesetzten Kontaktelektrodenmaterials eingesetzt werden kann, beispielsweise in der Form herkömmlicher Kupferfolien oder dgl. Denkbar ist hier beispielsweise eine Schicht aus gipsartigen Materialien, talkartigen Materialien oder dgl.

Die erfindungsgemäße Einbringung einer Schicht aus duktilem Material, bevorzugt mit geringer Mohs-Härte und/oder guter Prägbarkeit, sowie mit geringem E-Modul kann auch eingesetzt werden, wenn mehrschichtige Keramikstrukturen durch spezielle Brenn-Technologien hergestellt werden. D.h., es werden Mehrschichtstrukturen erstellt, beispielsweise indem piezokeramisches Material fein gemahlen, angeordnet und durch Brennen bei hohen Temperaturen nach der Art der Porzellanherstellung verfestigt wird. Werden die so hergestellten Piezokeramikabschnitte anschließend zu Piezokeramikaktoren bzw. Piezostapelaktoren verbunden, können ebenfalls die gemäß der Erfindung vorgeschlagene Schicht aus bevorzugt duktilem Material bzw. Material mit geringer Mohs-Härte und/oder vorteilhafter Prägbarkeit eingesetzt werden. Dabei ist eine Mohs-Härte von weniger als 2 bzw. eine Brinellhärte von weniger als ca. 20 bis 40 kp/mm² zu bevorzugen, da Material mit dieser Härte und/oder Prägbarkeit für die gewünschten Zwecke der Einebnung von Oberflächenrauhigkeiten bzw. Unebenheiten der Fügeflächen der Piezostapelabschnitte geeignet ist.

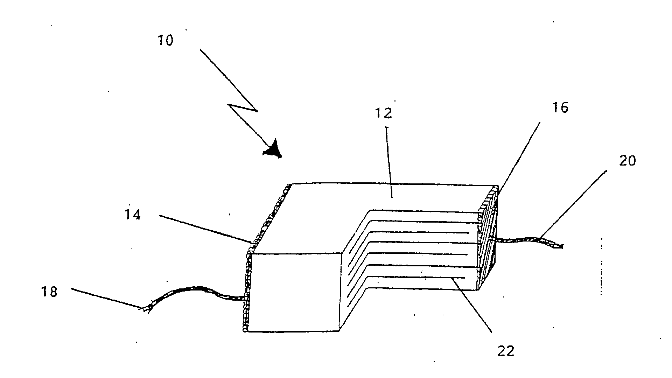

Nachfolgend wird die vorliegende Erfindung anhand der beigefügten Figur näher erläutert, die eine Prinzipdarstellung eines Piezostapelaktors in einer teilweisen Schnittdarstellung in perspektivischer Ansicht zeigt. Dabei werden auch unter Bezugnahme auf die Figur weitere Vorteile, Merkmale sowie Zielsetzungen gemäß der Erfindung offenbart.

In der Figur ist ein Piezostapelaktor allgemein durch das Bezugszeichen 10 gekennzeichnet. Der Aktor 10 weist eine Anzahl von Piezoscheiben 12 auf, die zu dem besagten Stapel 10 aufgeschichtet sind.

Zwischen den Piezoscheiben 12 sind Kontaktelektroden 22 vorgesehen. Die Kontaktelektroden 22 sind abwechselnd an gegenüberliegende Anschlusselektroden 14, 16 elektrisch angeschlossen. Die Anschlusselektroden 14, 16 werden über Kontaktierungsleiter 18, 20 beispielsweise an eine hochfrequente Spannungsquelle angeschlossen.

Die Kontaktelektroden 22, die in abwechselnder Reihenfolge entweder an die Anschlusselektrode 14 oder 16 angeschlossen sind, bilden immer jeweils zwischen den benachbarten Elektroden elektrische Felder aus, die das Piezomaterial zu einer Längenerstreckung anregen.

Die einzelnen Piezoscheiben 12 weisen eine Oberflächenrauhigkeit oder Oberflächenunebenheit auf, so dass beim Anordnen von Piezoscheiben aufeinander die Unebenheiten beispielsweise in der Form von kleinen Erhebungen unter mechanischer Belastung bereichsweise mechanische Spannungen in den Festkörper einer Piezoscheibe einleiten können, was insbesondere auch bei hochfrequenten Anregungen zu starkem mechanischen Stress führen kann, der eine Materialermüdung bereits nach kurzer Zeit nach sich ziehen kann.

Gemäß der Erfindung wird folglich eine Kontaktelektrode 22 aus einem relativ weichen Material hergestellt, bzw. wird eine herkömmliche Elektrode 22 auf einer oder auf beiden Seiten mit einer relativ weichen Schicht von etwa wenigstens 3 µm, bevorzugt mindestens 5 µm, versehen, so dass diese Schicht anstelle der Kontaktelektrode selbst die gewünschten Vorteile einer Idealisierung der Fuge zwischen aneinander angrenzenden Piezokeramikscheiben und damit einer höheren Steifigkeit eines Piezoscheibenstapels 10 bieten kann.

Wie bereits ausgeführt, kann nicht nur die Steifigkeit und damit die Leistungsfähigkeit eines Piezostapelaktors 10 durch die Erfindung ganz erheblich verbessert werden, sondern es ist darüber hinaus möglich, die Lebensdauer eines entsprechend gemäß der Erfindung ausgebildeten Piezostapelaktors 10 ganz erheblich zu steigern, da Unebenheiten ausgeglichen werden können und entsprechende Unebenheiten durch den Ausgleich durch die erfindungsgemäße Schicht keine mechanischen Spannungen mehr in eine piezokeramische Scheibe einleiten können.

Die Unebenheiten von piezokeramischen Scheiben prägen die Kontaktelektroden 22 bzw. deren Schicht(en) aus prägbarem Material, etwa reines Aluminium, und die Unebenheiten sowie die damit verbundenen Nachteile können vermieden werden.

Die Schicht 22 kann beispielsweise aus einer 10 µm dicken, aufgedampften oder galvanisch aufgebrachten Aluminiumschicht bestehen, über die einerseits auch ein elektrischer Anschluss erfolgen kann und die andererseits sämtliche erfindungsgemäßen Vorteile zu bieten vermag, da Aluminium vergleichsweise weich, d.h. prägbar, kostengünstig usw. ist. Auch passiviert sich Aluminium selbst, indem Aluminium eine dünne Schicht aus Aluminiumoxid an der Oberfläche bildet. Aluminium ist dadurch besonders beständig und dürfte als besonders kostengünstiges Material für die gewünschten Anwendungen gemäß der Erfindung zu bevorzugen sein.

Natürlich sind auch andere Materialien als Aluminium und dessen Legierungen sehr vorteilhaft, z.B. Zinn, Zink, Blei, Wismuth, Indium usw., insbesondere insoweit die Brinellhärte ≤ 40 kp/mm² ist und das E-Modul in etwa die Größenordnung des E-Moduls des Aktormaterials hat.

In Bezug auf weitere sehr vorteilhaft einsetzbare Materialien wird insoweit auf "Römpps Chemie-Lexikon", 9. Auflage, von Dr. Otto-Albrecht Neumüller, erschienen in der Franckh'sche Verlagshandlung, Stuttgart, verwiesen, die insofern zur Offenbarung der vorliegenden Anmeldung gezählt und hiermit ausdrücklich gemacht wird.

Durch die Anpassung zwischen dem Elektrodenmaterial und dem Material der Piezokeramik eines Aktorstapels ist es möglich eine bestmögliche Formschlüssigkeit zwischen Elektrode und Piezokeramik an den Kontaktfugen zu erreichen und die elastischen Eigenschaften der Gesamtanordnung möglichst nahe an den theoretischen Wert der Piezokeramik zu bringen. Dies ist insbesondere auch bei sogenannten diskret aus gesinterten Piezoeinzelscheiben gestapelten Verbünden wichtig, bei denen sich durch einen Pressvorgang das Elektrodenmaterial in die unebenen Piezokeramikoberflächen eindrückt, um eine bestmögliche Formschlüssigkeit zu schaffen. Geschieht dies infolge von mikroskopischen Hohlräumen in der Kontaktfuge nicht, so wird das mittlere E-Modul des Aktorstapels und als Äquivalent dazu das mechanische Arbeitsvermögen/Kraftentwicklungsvermögen verschlechtert.

Bevorzugt soll das E-Modul des Elektrodenmaterials dem der Keramik möglichst ähnlich sein; d.h., ein deutlich zu geringes E-Modul verschlechtert die Eigenschaften des Stapels; ein zu hohes E-Modul der Metallelektrode behindert die Querkontraktion der Piezoscheiben und damit auch das axiale Arbeitsverhalten des Stapels, bzw. führt zu mechanischem Stress.

Versuche haben bewiesen, dass bei ansonsten identischer Verarbeitungsweise ein Stapel unter Verwendung von Reinaluminiumelektroden deutlich bessere mechanische Eigenschaften (Steifigkeit, Kraftentwicklung) als z.B. bei Verwendung von Messingfolien vorzuweisen hat.

Nachfolgend beispielsweise einige E-Moduli

| | |
|---|---|
| Piezokeramik | 7 x 10³ kp/mm² |
| Reinaluminium | 7 x 10³ kp/mm² |
| Messing | 11 x 10³ kp/mm² |
| Kupfer | 13 x 10³ kp/mm². |

Explizite Versuche beim Aktorstapelbau bezüglich der Prägbarkeit eingelegter Metallfolien unter Druck ergaben, dass erwartungsgemäß Reinaluminium perfekt in die Oberflächenrauhigkeit der Keramik eingepresst wird. Messing zeigte jedoch unter den gleichen Bedingungen keinen Prägeeffekt.

## Patentansprüche

1. Verfahren zur Herstellung von Festkörperaktoren (10), insbesondere Piezoaktoren, wobei
- Aktorenabschnitte (12), insbesondere Piezoaktorenscheiben hergestellt werden,
- Kontaktelektroden (22) hergestellt werden, wobei diese mit den Aktorenabschnitten in Verbindung gebracht werden
**dadurch gekennzeichnet, dass** für die Kontaktelektroden (22) wenigstens eine Schicht mit einem Material mit einer Mohs-Härte von weniger als 2,5 verwendet wird, das bevorzugt ein E-Modul vergleichbar dem des Aktormaterials aufweist, und/oder, dass für die Kontaktelektroden (22) wenigstens eine Schicht mit einem Material mit einer Prägbarkeit von ≤ 40 kp/mm² (Brinellhärte) verwendet wird, dass bevorzugt ein E-Modul vergleichbar dem des Aktormaterials aufweist.

2. Verfahren nach Anspruch 1, **dadurch gekennzeichnet, dass** die Schicht mit einer Dicke vorgesehen wird, die Unebenheiten bzw. eine Porosität der angrenzenden Oberflächen der Aktorenabschnitte (12) ausgleicht.

3. Verfahren nach einem der Ansprüche 1 oder 2, **dadurch gekennzeichnet, dass** die Schicht (22) in der Form eine Folie eingebracht wird, aufgedampft bzw. abgeschieden, galvanisch oder andersartig aufgebracht wird.

4. Verfahren nach einem der Ansprüche 1 bis 3, **dadurch gekennzeichnet, dass** eine weitere Schicht, beispielsweise aus Kupfer bzw. einer Kupferlegierung, etwa in der Form einer Kupferfolie, eingebracht wird.

5. Festkörperaktor und insbesondere Piezokeramikaktor mit mehreren Aktorenabschnitten (12), insbesondere piezokeramischen Teilen oder Scheiben, wobei zwischen diesen Kontaktelektroden (22) angeordnet sind, **dadurch gekennzeichnet, dass** wenigstens eine Kontaktelektrode wenigstens eine Schicht mit einem Material mit einer Mohs-Härte von weniger als 2,5 bzw. einer Prägbarkeit mit einer Brinellhärte von ≤ 40 kp/mm², insbesondere ≤ 25 kp/mm² und bevorzugt mit einem E-Modul hat, das dem des Aktormaterials wenigstens in etwa nahe kommt.

6. Festkörperaktor nach Anspruch 5, **dadurch gekennzeichnet, dass** die Schicht elektrisch leitend ist.

7. Festkörperaktor nach einem der Ansprüche 5 oder 6, **dadurch gekennzeichnet, dass** die wenigstens eine Schicht eine Dicke von ca. mindestens 3 µm bis ungefähr 150 µm, bevorzugt 5 µm bis 100 µm aufweist.

8. Festkörperaktor nach einem der Ansprüche 5 bis 7, **dadurch gekennzeichnet, dass** die wenigstens eine Schicht aus Aluminium, Zinn, Zink, Blei, Indium, Vismuth, deren Legierungen und/oder Verbindungen hergestellt ist.

9. Festkörperaktor nach einem der Ansprüche 5 bis 7, **dadurch gekennzeichnet, dass** die wenigsten eine Schicht aus einem duktilen Material hergestellt ist.

10. Festkörperaktor nach einem der Ansprüche 5 bis 7, **dadurch gekennzeichnet, dass** die wenigstens eine Schicht zusätzlich zu einer Kontaktelektrodenschicht, beispielsweise in Form einer Kupferfolie, vorgesehen ist.
